# FASCICULE DE BREVET EUROPEEN

(11) **EP 3 921 660 B1**
(45) Date de publication et mention de la délivrance du brevet: **12.07.2023**
(21) Numéro de dépôt: 20707505.2
(22) Date de dépôt: 31.01.2020
(51) Int. Cl.: G01R 31/389, G01R 31/36, G01R 1/067, A41D 19/015, A41D 31/26, G01R 19/155, A41D 13/008

(54) **DISPOSITIF DE VÉRIFICATION D'ABSENCE DE TENSION D'UN CIRCUIT ÉLECTRIQUE**
VORRICHTUNG ZUR KONTROLLE DER SPANNUNGSFREIHEIT IN EINER ELEKTRISCHEN SCHALTUNG
DEVICE FOR CHECKING LACK OF VOLTAGE IN AN ELECTRIC CIRCUIT

(30) Priorité: 06.02.2019 FR 1901198
(43) Date de publication de la demande: 15.12.2021
(73) Titulaire: Neoratech, 10000 Troyes (FR)
(72) Inventeur: CAZOR, Thomas, 92500 RUEIL-MALMAISON (FR); ARBET-PONT, Mathias, 10000 TROYES (FR)
(74) Mandataire: Gevers & Orès
(86) Numéro de dépôt international: PCT/FR2020/050155
(87) Numéro de publication internationale: WO 2020/161415

(56) Documents cités:
- US-A1- 2004 160 410
- US-A1- 2012 182 720
- US-A1- 2017 099 888
- US-B1- 9 939 468

## Description

### DOMAINE TECHNIQUE

La présente invention se rapporte au domaine des dispositifs de sécurité lors des contrôles d'installations électriques et plus particulièrement un dispositif de vérification de tension d'un circuit électrique procurant une meilleure sécurité et un gain de temps pour les techniciens procédant à ces contrôles.

### ETAT DE LA TECHNIQUE

Dans le domaine de la maintenance des installations électriques, il est bien connu que, avant d'effectuer toute manipulation sur les lignes de tension électrique, les techniciens doivent préalablement passer quatre étapes indispensables de sécurité, à savoir l'identification, la séparation, la condamnation et la vérification d'absence de tension dite VAT. Cette étape de vérification d'absence de tension (VAT) est réalisée au moyen d'un appareil communément appelé DETEX (marque déposée) commercialisé par les établissements CATU, les techniciens devant se munir également de tout leur matériel de sécurité, à savoir un casque, des gants et un tapis isolant.

Ainsi, les techniciens doivent d'abord revêtir les gants avant de manipuler l'appareil de vérification d'absence de tension (VAT) afin de vérifier l'absence de tension. Toutefois, lesdits gants empêchent une manipulation aisée de sorte que certains techniciens ne se munissent pas des gants avant de réaliser les mesures avec l'appareil de vérification d'absence de tension prennent le risque de se faire électrocuter lors de la VAT.

Afin de remédier à ces inconvénients, on a déjà imaginé des dispositifs procurant une meilleure sécurité pour les techniciens. C'est le cas notamment du document CN104432685.

Le document CN104432685 décrit un vêtement de protection isolant doté d'un dispositif multimètre. Le vêtement protecteur isolant comprend un corps de vêtement protecteur isolant, se présentant sous la forme d'une veste dont les extrémités des manches sont munies de gants, un panneau d'affichage à cristaux liquides disposé sur un gant du corps du vêtement protecteur isolant, une sonde positive et une sonde négative disposées sur les doigts de deux gants respectivement, un module multimètre disposé sur la poitrine du corps du vêtement de protection isolant et le panneau d'affichage à cristaux liquides, la sonde positive et la sonde négative étant connectés au module multimètre par l'intermédiaire de fils.

Ce type de dispositif présente néanmoins l'inconvénient d'être peut ergonomique, encombrant, et onéreux, outres le fait que, en cas de grande chaleur, d'être inconfortable pour les techniciens.

Le document US2017/099888 décrit un gant de sécurité électrique comprenant un moniteur de tension avec une affichage visuel.

### EXPOSÉ DE L'INVENTION

L'un des buts de l'invention est donc de remédier à au moins un de ces inconvénients en proposant un dispositif de vérification d'absence de tension d'un circuit électrique de conception simple et peu onéreuse, peu encombrant et ergonomique et procurant une sécurité accrue pour les techniciens.

A cet effet et conformément à l'invention, il est proposé un dispositif de vérification d'absence de tension d'un circuit électrique comprenant une paire de gants souples et isolants, un dispositif vérificateur d'absence de tension comprenant au moins un écran d'affichage et deux pointes de touche ; ledit dispositif étant remarquable en ce que le dispositif vérificateur d'absence de tension est réalisé dans un circuit électronique souple, comprenant un substrat souple, et noyé dans un premier gant de la paire de gants souples et isolants, ledit écran d'affichage étant affleurant à la surface dudit gant.

De préférence, l'écran d'affichage du dispositif vérificateur d'absence de tension consiste en un écran LCD souple.

Chaque pointe de touche comprend un corps isolant, une pointe conductrice et un capuchon souple amovible apte à protéger ladite pointe conductrice.

Selon une première variante d'exécution, le dispositif vérificateur d'absence de tension comprend deux bornes femelles moulées dans le gant et aptes à recevoir les bornes males des pointes de touche.

Selon une seconde variante d'exécution, le dispositif vérificateur d'absence de tension comprend un dévidoir enrouleur recevant les câbles des pointes de touche.

Selon une autre variante d'exécution, le dispositif vérificateur d'absence de tension comprend un émetteur-récepteur apte à communiquer avec un émetteur-récepteur positionné dans le corps isolant de chaque pointe de touche.

De préférence, ledit dispositif vérificateur d'absence de tension est positionné sur le dessus du gant et est amovible.

Par ailleurs, le second gant de la paire de gant comprend avantageusement au moins un capteur apte à détecter le port du gant par un opérateur.

De manière avantageuse, le dispositif comprend des moyens de détection d'un potentiel électrique à une distance prédéterminée.

Lesdits moyens de détection comprennent au moins un capteur apte à détecter un champ de potentiel électrique généré par un champ électrique, un circuit de commande apte à analyser ledit potentiel électrique et à le comparer à une valeur seuil prédéterminée et connecter à des moyens de signalisation.

Ledit capteur consiste en un solénoïde et les moyens de signalisation consistent en des moyens de signalisation sonores et/ou lumineux.

### BRÈVE DESCRIPTION DES FIGURES

D'autres avantages et caractéristiques ressortiront mieux de la description qui va suivre, de plusieurs variantes d'exécution du dispositif de vérification d'absence de tension d'un circuit électrique suivant l'invention, données à titre d'exemples non limitatifs, à partir des dessins annexés sur lesquels :
- la figure 1 est une vue en perspective du dispositif suivant l'invention porté par un technicien,
- la figure 2 est une vue en perspective des gants du dispositif suivant l'invention,
- la figure 3 est une vue en perspective d'un gant du dispositif suivant l'invention, en position enroulée, lors qu'il n'est pas utilisé,
- la figure 4 est une vue en perspective d'une variante d'exécution du dispositif suivant l'invention porté par un technicien.

### DESCRIPTION DÉTAILLÉE

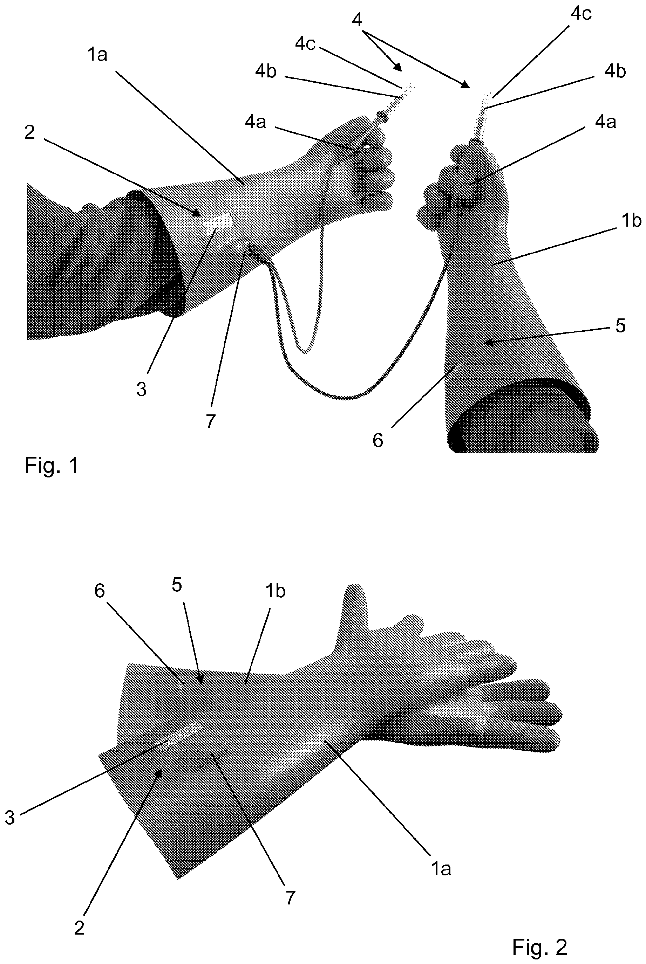

En référence aux figures 1 et 2, le dispositif de vérification d'absence de tension d'un circuit électrique suivant l'invention comprend une paire de gants 1a,1b souples et électriquement isolants, un dispositif vérificateur d'absence de tension 2 comprenant au moins un écran d'affichage 3 et deux pointes de touche 4, de préférence des pointes de touche 4 d'indice de protection IP2X bien connu de l'homme du métier. Les gants 1a, 1b consistent en des gants bien connus de l'homme du métier et sont conformes aux exigences des normes CEI 60903 et NF EN 60903 notamment. Ils sont usuellement obtenu dans du latex, offrant de hautes caractéristiques diélectriques, et peuvent éventuellement consister en des gants dits composites qui offrent une protection mécanique supérieure aux perforations et aux déchirures. De manière particulièrement avantageuse, le dispositif vérificateur d'absence de tension 2 est réalisé dans un circuit électronique souple, non représenté sur les figures, comprenant un substrat souple, et noyé dans un premier gant 1a de la paire de gants 1a,1b souples et isolants, et ledit écran d'affichage 3 étant affleurant à la surface dudit gant 1a. Ledit dispositif vérificateur d'absence de tension 2 comprend des moyens de repérage de la phase et du neutre, des moyens de test de continuité et un contrôleur de rotation de phases, ledit dispositif vérificateur d'absence de tension 2 présentant un indice de protection IP65.

Par exemple, le circuit électronique souple comprend un premier substrat souple comprenant une première série de contacts électriques, délimitant d'une part une première surface de contact, et d'autre part une première surface de substrat, dépourvue de contacts électriques, un deuxième substrat souple comprenant une deuxième série de contacts, délimitant d'une part une deuxième surface de contact, et d'autre part une deuxième surface de substrat, dépourvue de contacts électriques, ledit contacteur électrique comprenant de plus au moins un élément intercalaire disposé entre lesdites première et deuxième surfaces de substrat. Ledit circuit est obtenu par la mise en oeuvre d'une étape de dépôt par sérigraphie d'au moins une première couche de vernis polymérisable sur ladite première surface de substrat, d'apposition de ladite deuxième surface de substrat sur la couche de vernis précédemment sérigraphiée, en regard de ladite première surface de substrat, de façon à ce que le vernis forme ledit élément intercalaire et de polymérisation de la couche de vernis polymérisable précédemment sérigraphiée, sur laquelle est apposée la deuxième surface de substrat tel que décrit dans la demande de brevet français FR 3 027 153 par exemple.

Il va de soi que le circuit électronique souple pourra être obtenu selon tout autre procédé bien connu de l'homme du métier sans pour autant sortir du cadre de l'invention.

Par ailleurs, de préférence, l'écran d'affichage 3 du dispositif vérificateur d'absence de tension 2 consiste en un écran LCD souple. Il est vient évident que l'écran LCD souple pourra être substitué par tout autre écran d'affichage souple ou non bien connu de l'homme du métier sans pour autant sortir du cadre de l'invention.

Chaque pointe de touche 4 comprend un corps isolant 4a, une pointe conductrice 4b et un capuchon 4c souple amovible apte à protéger ladite pointe conductrice 4b.

Par ailleurs, le second gant 1b de la paire de gants 1a, 1b comprend avantageusement au moins un capteur apte à détecter le port du gant par un opérateur, ledit capteur n'étant pas représenté sur les figures.

De plus, et de manière avantageuse, le dispositif comprend des moyens de détection 5 d'un potentiel électrique à une distance prédéterminée. Lesdits moyens de détection 5 comprennent au moins un capteur, non représenté sur les figures, apte à détecter un champ de potentiel électrique généré par un champ électrique, et un circuit de commande apte à analyser ledit potentiel électrique et à le comparer à une valeur seuil prédéterminée, ledit circuit de commande étant connecté à des moyens de signalisation 6. Ledit capteur consiste en un solénoïde et les moyens de signalisation consistent en des moyens de signalisation sonores et/ou lumineux.

Il va de soi que le capteur pourra consister dans tout autre capteur équivalent bien connu de l'homme du métier sans pour autant sortir du cadre de l'invention.

Ainsi, lorsqu'un champ de potentiel électrique est détecté par le capteur, le circuit de commande génère un signal d'alarme intermittent et audible, qui a une cadence de répétition variant en proportion de la force du champ et, un signal d'alarme visible. On notera que les moyens de détection 5 ne comporte pas de bouton marche-arrêt, les moyens de détection étant désactivé en étant disposé dans un étui de transport blindé. Accessoirement, le dispositif indique la présence de courant par un signal lumineux permanent de couleur rouge et un signal sonore supérieur à 80dB(A).

Dans cet exemple de réalisation, le dispositif vérificateur d'absence de tension 2 est positionné dans un logement pratiqué sur la face interne du gant 1a, à proximité de l'extrémité proximale dudit gant 1a. De plus, ledit dispositif vérificateur d'absence de tension 2 est avantageusement amovible de sorte que, lorsque les gants 1a, 1b sont usés, ce dernier est retiré est positionné dans le logement d'un nouveau gant 1a ce qui permet de réduire le coût du dispositif suivant l'invention. De plus, le dispositif vérificateur d'absence de tension 2 comprend deux bornes femelles moulées 7 dans le gant 1a et aptes à recevoir les bornes males des pointes de touche 4.

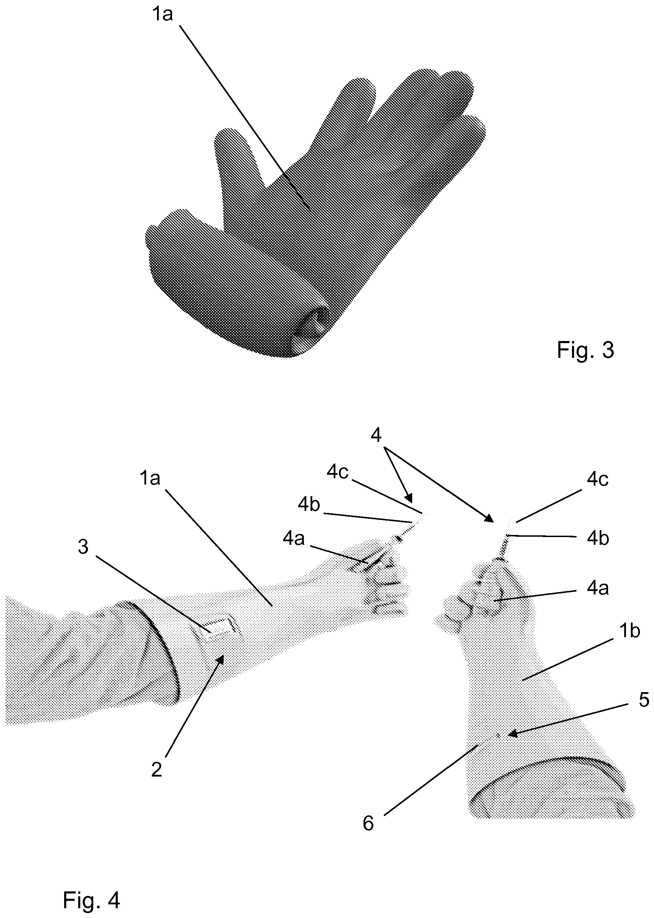

On observera, en référence à la figure 3, que les gants 1a, 1b peuvent être aisément roulés pour leur stockage grâce à la flexibilité du dispositif vérificateur d'absence de tension 2, sans avoir à retirer ledit dispositif vérificateur d'absence de tension 2 de son logement.

Selon une variante d'exécution du dispositif suivant l'invention, non représentée sur les figures, le dispositif vérificateur d'absence de tension pourra comprendre un dévidoir enrouleur recevant les câbles des pointes de touche 4.

Selon une autre variante d'exécution du dispositif suivant l'invention, en référence à la figure 4, le dispositif de vérification d'absence de tension d'un circuit électrique suivant l'invention comprend de la même manière que précédemment une paire de gants 1a,1b souples et électriquement isolants, un dispositif vérificateur d'absence de tension 2 comprenant au moins un écran d'affichage 3 et deux pointes de touche 4. Ledit dispositif vérificateur d'absence de tension 2 est réalisé dans un circuit électronique souple, non représenté sur les figures, comprenant un substrat souple, et noyé dans un premier gant 1a de la paire de gants 1a,1b souples et isolants, et ledit écran d'affichage 3 étant affleurant à la surface dudit gant 1a. Par ailleurs, de préférence, l'écran d'affichage 3 du dispositif vérificateur d'absence de tension 2 consiste en un écran LCD souple. Il est vient évident que l'écran LCD souple pourra être substitué par tout autre écran d'affichage souple ou non bien connu de l'homme du métier sans pour autant sortir du cadre de l'invention.

Chaque pointe de touche 4 comprend un corps isolant 4a, une pointe conductrice 4b et un capuchon 4c souple amovible apte à protéger ladite pointe conductrice 4b.

Par ailleurs, le second gant 1b de la paire de gants 1a, 1b comprend avantageusement au moins un capteur apte à détecter le port du gant par un opérateur, ledit capteur n'étant pas représenté sur les figures.

De plus, et de manière avantageuse, le dispositif comprend des moyens de détection 5 d'un potentiel électrique à une distance prédéterminée. Lesdits moyens de détection 5 comprennent au moins un capteur, non représenté sur les figures, apte à détecter un champ de potentiel électrique généré par un champ électrique, et un circuit de commande apte à analyser ledit potentiel électrique et à le comparer à une valeur seuil prédéterminée, ledit circuit de commande étant connecté à des moyens de signalisation 6. Ledit capteur consiste en un solénoïde et les moyens de signalisation consistent en des moyens de signalisation sonores et/ou lumineux.

Le dispositif se distingue de celui décrit précédemment par le fait que le dispositif vérificateur d'absence de tension comprend un émetteur-récepteur, non représenté sur les figures, apte à communiquer avec un émetteur-récepteur, non représenté sur les figures, positionné dans le corps isolant de chaque pointe de touche 4.

Enfin, il est bien entendu que la présente invention n'est en aucune façon limitée aux formes de réalisations décrites ci-dessus et que bien des modifications peuvent y être apportées sans sortir du cadre des revendications annexées.

## Revendications

1. Dispositif de vérification d'absence de tension d'un circuit électrique comprenant une paire de gants (1a, 1b) souples et isolants, un dispositif vérificateur d'absence de tension (2) comprenant au moins un écran d'affichage (3) et deux pointes de touche (4), **caractérisé en ce que** le dispositif vérificateur d'absence de tension (2) est réalisé dans un circuit électronique souple, comprenant un substrat souple, et noyé dans un premier gant (1a) de la paire de gants souples et isolants (1a, 1b), ledit écran d'affichage (3) étant affleurant à la surface dudit gant (1a).

2. Dispositif suivant la revendication 1,
**caractérisé en ce que** l'écran d'affichage (3) du dispositif vérificateur d'absence de tension (2) consiste en un écran LCD souple.

3. Dispositif suivant l'une quelconque des revendications 1 ou 2,
**caractérisé en ce que** chaque pointe de touche (4) comprend un corps isolant (4a), une pointe conductrice (4b) et un capuchon (4c) souple amovible apte à protéger ladite pointe conductrice (4b).

4. Dispositif suivant l'une quelconque des revendications 1 à 3,
**caractérisé en ce que** le dispositif vérificateur d'absence de tension (2) comprend deux bornes femelles (7) moulées dans le gant (1a) et aptes à recevoir les bornes males des pointes de touche (4).

5. Dispositif suivant l'une quelconque des revendications 1 à 3,
**caractérisé en ce que** le dispositif vérificateur d'absence de tension (2) comprend un dévidoir enrouleur recevant les câbles des pointes de touche (4).

6. Dispositif suivant l'une quelconque des revendications 1 à 3,
**caractérisé en ce que** le dispositif vérificateur d'absence de tension (2) comprend un émetteur-récepteur apte à communiquer avec un émetteur-récepteur positionné dans le corps isolant (4a) de chaque pointe de touche (4).

7. Dispositif suivant l'une quelconque des revendications 1 à 6,
**caractérisé en ce que** le second gant (1b) de la paire de gants comprend au moins un capteur apte à détecter le port du gant par un opérateur.

8. Dispositif suivant l'une quelconque des revendications 1 à 7,
**caractérisé en ce que** le dispositif vérificateur d'absence de tension (2) est positionné sur le dessus du gant (1a).

9. Dispositif suivant l'une quelconque des revendications 1 à 8,
**caractérisé en ce qu'**il comprend des moyens de détection (5) d'un potentiel électrique à une distance prédéterminée.

10. Dispositif suivant la revendication 9,
**caractérisé en ce que** lesdits moyens de détection (5) comprennent au moins un capteur apte à détecter un champ de potentiel électrique généré par un champ électrique, et un circuit de commande apte à analyser ledit potentiel électrique et à le comparer à une valeur seuil prédéterminée, ledit circuit de commande étant connecté à des moyens de signalisation (6).

11. Dispositif suivant la revendication 10,
**caractérisé en ce que** le capteur consiste en un solénoïde.

12. Dispositif suivant l'une quelconque des revendications 10 ou 11,
**caractérisé en ce que** les moyens de signalisation (6) consistent en des moyens de signalisation sonores et/ou lumineux.

13. Dispositif suivant l'une quelconque des revendications 1 à 12,
**caractérisé en ce que** le dispositif vérificateur d'absence de tension (2) est amovible.

## Patentansprüche

1. Vorrichtung zur Überprüfung der Spannungsfreiheit einer elektrischen Schaltung, umfassend ein Paar nachgiebiger und isolierender Handschuhe (1a, 1b), eine Spannungsfreiheit-Überprüfungsvorrichtung (2), die mindestens einen Anzeigebildschirm (3) und zwei Berührungsspitzen (4) umfasst,
**dadurch gekennzeichnet, dass** die Spannungsfreiheit-Überprüfungsvorrichtung (2) in einer nachgiebigen elektronischen Schaltung umgesetzt ist, die ein nachgiebiges Substrat umfasst, und in einem ersten Handschuh (1a) des Paars nachgiebiger und isolierender Handschuhe (1a, 1b) versenkt ist, wobei der Anzeigebildschirm (3) mit der Oberfläche des Handschuhs (1a) bündig ist.

2. Vorrichtung nach Anspruch 1,
**dadurch gekennzeichnet, dass** der Anzeigebildschirm (3) der Spannungsfreiheit-Überprüfungsvorrichtung (2) aus einem nachgiebigen LCD-Bildschirm besteht.

3. Vorrichtung nach einem der Ansprüche 1 oder 2,
**dadurch gekennzeichnet, dass** jede Berührungsspitze (4a) einen isolierenden Körper (4a), eine leitfähige Spitze (4b) und eine abnehmbare nachgiebige Kappe (4c), die geeignet ist, die leitfähige Spitze (4b) zu schützen, umfasst.

4. Vorrichtung nach einem der Ansprüche 1 bis 3,
**dadurch gekennzeichnet, dass** die Spannungsfreiheit-Überprüfungsvorrichtung (2) zwei weibliche Anschlüsse (7) umfasst, die im Handschuh (1a) gebildet sind und geeignet sind, die männlichen Anschlüsse der Berührungsspitzen (4) aufzunehmen.

5. Vorrichtung nach einem der Ansprüche 1 bis 3,
**dadurch gekennzeichnet, dass** die Spannungsfreiheit-Überprüfungsvorrichtung (2) eine Wickelspule umfasst, die die Kabel der Berührungsspitzen (4) aufnimmt.

6. Vorrichtung nach einem der Ansprüche 1 bis 3,
**dadurch gekennzeichnet, dass** die Spannungsfreiheit-Überprüfungsvorrichtung (2) einen Sender-Empfänger umfasst, der geeignet ist, mit einem im isolierenden Körper (4a) jeder Berührungsspitze (4) angeordneten Sender-Empfänger zu kommunizieren.

7. Vorrichtung nach einem der Ansprüche 1 bis 6,
**dadurch gekennzeichnet, dass** der zweite Handschuh (1b) des Handschuhpaars mindestens einen Sensor umfasst, der geeignet ist, das Tragen des Handschuhs durch einen Betreiber zu erfassen.

8. Vorrichtung nach einem der Ansprüche 1 bis 7,
**dadurch gekennzeichnet, dass** die Spannungsfreiheit-Überprüfungsvorrichtung (2) auf der Oberseite des Handschuhs (1a) angeordnet ist.

9. Vorrichtung nach einem der Ansprüche 1 bis 8,
**dadurch gekennzeichnet, dass** sie Erfassungsmittel (5) eines elektrischen Potentials in einem vorbestimmten Abstand umfasst.

10. Vorrichtung nach Anspruch 9,
**dadurch gekennzeichnet, dass** die Erfassungsmittel (5) mindestens einen Sensor, der geeignet ist, ein elektrisches Potentialfeld zu erfassen, das von einem elektrischen Feld erzeugt wird, und eine Steuerschaltung umfassen, die geeignet ist, das elektrische Potentialfeld zu analysieren und es mit einem vorbestimmten Schwellenwert zu vergleichen, wobei die Steuerschaltung mit Signalisierungsmitteln (6) verbunden ist.

11. Vorrichtung nach Anspruch 10,
**dadurch gekennzeichnet, dass** der Sensor aus einem Solenoid besteht.

12. Vorrichtung nach einem der Ansprüche 10 oder 11,
**dadurch gekennzeichnet, dass** die Signalisierungsmittel (6) aus akustischen und/oder Lichtsignalisierungsmitteln bestehen.

13. Vorrichtung nach einem der Ansprüche 1 bis 12,
**dadurch gekennzeichnet, dass** die Spannungsfreiheit-Überprüfungsvorrichtung (2) abnehmbar ist.

## Claims

1. A device for checking lack of voltage in an electric circuit, comprising a pair of flexible and insulating gloves (1a, 1b), a lack of voltage checking device (2) comprising at least one display screen (3) and two contact points (4),
**characterized in that** the lack of voltage checking device (2) is formed in a flexible electronic circuit, comprising a flexible substrate, and embedded in a first glove (1a) of the pair of flexible and insulating gloves (1a, 1b), said display screen (3) being flush on the surface of said glove (1a).

2. The device according to claim 1,
**characterized in that** the display screen (3) of the lack of voltage checking device (2) consists of a flexible LCD screen.

3. The device according to any one of claims 1 or 2,
**characterised in that** each contact point (4) comprises an insulating body (4a), a conductive tip (4b) and a removable flexible cap (4c) adapted to protect said conductive tip (4b).

4. The device according to any one of claims 1 to 3,
**characterised in that** the lack of voltage checking device (2) comprises two female terminals (7) moulded in the glove (1a) and adapted to receive the male terminals of the contact points (4).

5. The device according to any one of claims 1 to 3,
**characterised in that** the lack of voltage checking device (2) comprises a reel for receiving the cables of the contact points (4).

6. The device according to any one of claims 1 to 3,
**characterised in that** the lack of voltage checking device (2) comprises a transceiver adapted to communicate with a transceiver positioned in the insulating body (4a) of each contact point (4).

7. The device according to any one of claims 1 to 6,
**characterised in that** the second glove (1b) of the pair of gloves comprises at least one sensor adapted to detect the wearing of the glove by an operator.

8. The device according to any one of claims 1 to 7,
**characterised in that** the lack of voltage checking device (2) is positioned on top of the glove (1a).

9. The device according to any one of claims 1 to 8,
**characterised in that** it comprises means (5) for detecting an electrical potential at a predetermined distance.

10. The device according to claim 9,
**characterized in that** said detecting means (5) comprise at least a sensor adapted to detect an electric potential field generated by an electric field, a control circuit adapted to analyse said electric potential and to compare it with a predetermined threshold value, said control circuit being connect to signalling means (6).

11. The device according to claim 10,
**characterised in that** the sensor consists of a solenoid.

12. The device according to any one of claims 10 or 11,
**characterised in that** the signalling means (6) consist of sound and/or light signalling means.

13. The device according to any one of claims 1 to 12,
**characterised in that** the lack of voltage checking device (2) is removable.
